# EUROPÄISCHE PATENTSCHRIFT

(11) **EP 3 048 671 B1**
(45) Veröffentlichungstag und Bekanntmachung des Hinweises auf die Patenterteilung: **22.11.2017**
(21) Anmeldenummer: 16151744.6
(22) Anmeldetag: 18.01.2016
(51) Int. Cl.: H05K 7/14

(54) **EINBAUBUCHSE FÜR EINE KOMMUNIKATIONSEINHEIT SOWIE KOMMUNIKATIONSEINHEIT**
BUILT-IN SOCKET FOR A COMMUNICATION UNIT AND COMMUNICATION UNIT
DOUILLE ENCASTRABLE POUR UNE UNITÉ DE COMMUNICATION ET UNITÉ DE COMMUNICATION

(30) Priorität: 23.01.2015 DE 102015201118
(43) Veröffentlichungstag der Anmeldung: 27.07.2016
(73) Patentinhaber: Power Plus Communications AG, 68167 Mannheim (DE)
(72) Erfinder: Veselcic, Marko, 67122 Altrip (DE)
(74) Vertreter: Patent- und Rechtsanwälte Ullrich & Naumann

(56) Entgegenhaltungen:
- CN-A- 103 560 356
- CN-U- 202 004 172
- CN-Y- 201 251 724
- US-A- 6 050 853

## Beschreibung

Die Erfindung betrifft eine Einbaubuchse für eine Kommunikationseinheit in einem Tragschienengehäuse, mit einem Grundkörper, an dem eine Anschlussseite und eine Einsteckseite ausgebildet ist, wobei an der Anschlussseite Anschlussmittel zum Verbinden der Einbaubuchse mit Leiterbahnen auf einer Platine der Kommunikationseinheit ausgebildet sind, wobei in der Einsteckseite eine Einstecköffnung zur Aufnahme eines korrespondierenden Steckers ausgebildet ist und wobei durch die Einstecköffnung eine Achse definiert ist, entlang der ein eingesteckter Stecker angeordnet ist. Die Erfindung betrifft ferner eine entsprechende Kommunikationseinheit, insbesondere ein SmartMeter-Gateway.

Kommunikationssysteme bestehen häufig aus mehreren separaten Einheiten, die kommunizierend miteinander verbunden sind. Als Beispiele für derartige Systeme sei auf Telefonanlagen, Hausautomatisierungssysteme, moderne Türsprechanlagen oder SmartMeter-Systeme (Systeme mit einem oder mehreren intelligenten Zählern meist für Strom, Gas oder Wasser) verwiesen. In vielen Fällen sind die einzelnen Einheiten des Kommunikationssystems mit Steckverbindern untereinander verbunden. Insbesondere bei IP (Internet Protocol)-basierter Kommunikation haben sich RJ (Registered Jack)-Steckverbinder etabliert, die von der US-amerikanischen FCC (Federal Communications Commission) genormt sind. Bei kupferkabel-gebundener Kommunikation über Ethernet ist insbesondere RJ45 weit verbreitet, bei dem bei Vollbeschaltung acht Kontaktpositionen mit acht Kontakten vorgesehen sind (8P8C-Modularstecker bzw. -buchse) und dessen Verkabelung nach EIA/TIA-568 standardisiert ist.

Zum Verbinden einer Kommunikationseinheit mit einer anderen ist in der Kommunikationseinheit jeweils eine Einbaubuchse vorgesehen, in die ein korrespondierender Stecker eingesteckt werden kann. Mit dem Stecker ist ein mehradriges Kommunikationskabel verbunden, an dessen anderen Ende üblicherweise ebenso ein Stecker zum Einstecken in eine andere Kommunikationseinheit angeordnet ist. Eine derartige Einbaubuchse weist einen Grundkörper auf, der verschiedentlich ausgebildet sein kann, an dem aber zumindest eine Anschlussseite und eine Einsteckseite ausgebildet sind. An der Anschlussseite sind Anschlussmittel angeordnet, die zum Verbinden der Einbaubuchse mit Leiterbahnen auf einer Platine ausgebildet sind, wobei die Anschlussmittel meist mit den Leiterbahnen verlötet werden. Mit Verbinden der Einbaubuchse mit einer Platine ist die Anschlussseite im Wesentlichen parallel zu dieser Platine. In der Einsteckseite ist eine Einstecköffnung ausgebildet, in die der korrespondierende Stecker einsteckbar ist. Durch die Ausgestaltung der Einstecköffnung ist eine Achse definiert, entlang der ein Stecker nach dem Einstecken in die Einstecköffnung angeordnet ist. Bei vielen Steckverbinder, beispielsweise bei RJ45, fällt die Einsteckrichtung, entlang der ein Stecker in die Einstecköffnung eingesteckt wird, im Wesentlichen mit der Achse der Einstecköffnung zusammen.

Kommunikationseinheiten können in den verschiedensten Gehäusen angeordnet sein. Neben weit verbreiteten Kommunikationseinheiten für 19"-Racks oder zur Montage an einer Wand sind auch Kommunikationseinheiten in Tragschienengehäusen gebräuchlich. Sehr häufig werden dabei Tragschienen in Form einer Hutschiene nach EN 50022, auch bekannt als DIN Rail, verwendet, die in Elektroverteilern weite Verbreitung finden. In Deutschland sind die Abmessungen von zugehörigen Gehäusen sowie deren Einbaumaße nach DIN 43880 genormt. Danach ist die Oberfläche einer Berührungsschutzabdeckung im Abstand von 52 mm von der Oberkante der Hutschiene angeordnet, die die Kontakte der einzelnen Hutschienengehäuse gegen Berührung und Manipulation schützen. Das Hutschienengehäuse selbst darf die Berührungsschutzabdeckung maximal um 10 mm überragen, so dass das Hutschienengehäuse von der Oberkante der Hutschiene gemessen maximal 62 mm hoch sein darf. Im Abstand von 70 mm von der Hutschiene ist eine Türe oder eine andere Frontverkleidung angeordnet, die den gesamten Verteiler mit den einzelnen Hutschienengehäusen und der Berührungsschutzabdeckung abschließt. Innerhalb dieser Vorgaben muss sich ein normgerecht aufgebautes Hutschienengehäuse bewegen. Bei anderen Tragschienensystemen gelten ähnliche Vorgaben.

In der Praxis sind verschiedenste Kommunikationseinheiten in Hutschienengehäusen bekannt. Beispiele hierfür sind IP-Gateways für Türsprechanlagen (beispielsweise von der Firma Gira), IP-Gateways oder andere Interfaces für einen KNX-Bus (beispielsweise von der Firma Weinzierl Engineering GmbH) oder SmartMeter-Gateways. Auf letztere wird nachfolgend beispielshaft genauer eingegangen.

In Deutschland sind gewisse Ausgestaltungen eines SmartMeter-Gateways nach dem Gesetz über die Elektrizitäts- und Gasversorgung (EnWG) und dort insbesondere die §§ 21e, 21f und 21i vorgeschrieben, die in einem Schutzprofil und einer Technischen Richtlinie des Bundesamts für Sicherheit in der Informationstechnik (BSI) weiter konkretisiert sind. Die Aufgabe eines SmartMeter-Gateways besteht darin, eine verschlüsselte Kommunikation zwischen einem SmartMeter und dem Versorgungsunternehmen (Energie, Wasser, etc.) sowie eine Beschränkung des Zugriffs auf bekannte Teilnehmer und Geräte sicherzustellen. Hierzu weist das SmartMeter-Gateway mehrere Schnittstellen auf, insbesondere eine Schnittstelle zu einem WAN (Wide Area Network), eine Schnittstelle zu einem LMN (Local Metrological Network) und eine Schnittstelle zu einem HAN (Home Area Network). Die HAN-Schnittstelle ist dabei für den Endkunden vorgesehen, um beispielsweise Verbrauchs- und/oder Einspeisewerte abzufragen. Gleichzeitig können über die HAN-Schnittstelle steuerbare Geräte angesteuert werden oder ein Techniker kann einen Systemstand abfragen. Daher ist die HAN-Schnittstelle im Gehäuse für einen Endkunden zugänglich angeordnet, d.h. ein zugehöriger Anschluss, meist eine RJ45-Buchse, liegt an der Frontseite des Gehäuses vor der Berührungsschutzabdeckung. In der Praxis sind bei RJ45-Einbaubuchsen im Wesentlichen drei Varianten gebräuchlich: Eine Variante mit einer Achse der Einstecköffnung senkrecht zu der Platine, auf der die Einbaubuchse befestigt ist, eine Variante mit der Achse der Einstecköffnung parallel zu der Platine und eine Variante, bei der die Achse der Einstecköffnung relativ zu der Platine einen Winkel von 45° ±3° einschließt. Die erstgenannte Variante ist beispielsweise bei dem bereits erwähnten KNX-IP-Gateway der Firma Weinzierl Engineering GmbH verwendet. Nachteilig hieran ist, dass ein RJ45-Stecker weit über die Oberseite des Hutschienengehäuses hinausragt. Die zweitgenannte Variante ist beispielsweise bei dem bereits angesprochenen Türsprechsystem-IP-Gateway der Firma Gira eingesetzt. Nachteilig hieran ist, dass das Hutschienengehäuse nicht die Einbaumaße für Hutschienengehäuse einhalten kann, da das Gehäuse zwangsläufig um mehr als 10 mm über die Berührungsschutzabdeckung hinausragt. Die letztgenannte Variante ist bei SmartMeter-Gateways gebräuchlich. Nachteilig daran ist jedoch, dass keine Standard-RJ45-Kabel mit Knickschutzhüllen verwendet werden können. Meist kommen stattdessen Spezialkabel zum Einsatz, wie beispielsweise Slimline-Patchkabel der Marke Shiverpeaks. Alternativ werden Kabel eingesetzt, die keine Knickschutzhüllen aufweisen. Allerdings sind sowohl Spezialkabel als auch Kabel ohne Knickschutzhüllen Kabel weniger belastbar und daher viel anfällig gegen Beschädigung. Das Dokument US6050853 offenbart einen relativ zur Platinenebene um 11° geneigten Steckverbinder. Die hiermit zu lösenden Aufgabe besteht in einer verbesserten Nutzung des Bauraums auf einer Platine. Der vorliegenden Erfindung liegt daher die Aufgabe zugrunde, eine Einbaubuchse sowie eine Kommunikationseinheit der eingangs genannten Art derart auszugestalten und weiterzubilden, dass auf die Verwendung von Spezialkabeln zur Verbindung mit der Einbaubuchse bzw. der Kommunikationseinheit verzichtet werden kann. Erfindungsgemäß wird die voranstehende Aufgabe durch die Merkmale des Anspruchs 1 gelöst. Danach ist die in Rede stehende Einbaubuchse dadurch gekennzeichnet, dass Anschlussseite und Einstecköffnung derart aufeinander abgestimmt sind, dass die Achse der Einstecköffnung relativ zu einer mit der Einbaubuchse verbundenen Platine einen Winkel zwischen 15° und 23° einschließt.

Hinsichtlich einer Kommunikationseinheit ist die voranstehende Aufgabe durch die Merkmale des Anspruchs 11 gelöst. Danach umfasst die Kommunikationseinheit ein Tragschienengehäuse, insbesondere ein Hutschienengehäuse, mindestens eine Platine und eine erfindungsgemäße Einbaubuchse, wobei das Gehäuse eine zur Tragschiene zugewandte Seite - Montageseite - und eine Frontseite aufweist, wobei die Einbaubuchse mit einer der mindestens einen Platine - erste Platine - verbunden ist, wobei die erste Platine parallel zu der Montageseite angeordnet ist, wodurch die Achse der Einstecköffnung relativ zu der Montageseite einen Winkel zwischen 15° und 23° einschließt.

In erfindungsgemäßer Weise ist zunächst erkannt worden, dass durch Auswahl eines bestimmten Winkelbereichs zwischen der Achse der Einstecköffnung und einer mit der Einbaubuchse verbundenen Platine auf einfache Art und Weise auf die Verwendung von Spezialkabeln verzichtet werden kann und gleichzeitig die benötigten Einbaumaße, beispielsweise bei Hutschienengehäusen, eingehalten werden können. Gebräuchliche RJ45-Kabel weisen üblicherweise einen Biegeradius auf, der achtmal der Durchmesser des RJ45-Kabels ist. Bei Auswahl eines Winkels zwischen 15° und 23° (Randwerte jeweils eingeschlossen) können sowohl der Biegeradius des Kabels als auch die maximal zulässigen Abmessungen eingehalten werden. Der Erfinder hat festgestellt, dass ab einem Winkel von 15° der RJ45-Stecker oberhalb einer Berührungsschutzabdeckung eingesteckt werden kann. Bis zu einem Winkel von 23° ist der RJ45-Stecker so bezüglich des Hutschienengehäuses angeordnet, dass er wieder gut aus der Einbaubuchse entnommen werden kann. Durch die erfindungsgemäße Auswahl des Winkels zwischen 15° und 23° kann in eine Einbaubuchse in einem Hutschienengehäuse ein Standard-RJ45-Stecker eingesteckt werden, ohne die üblichen Handhabungsanforderungen, wie einfaches Einstecken oder einfachen Entnehmen des RJ45-Steckers zu beeinflussen. Gleichzeitig können die minimalen Biegeradien, die maximalen Ausmaße des Gehäuses und andere Randbedingungen eingehalten werden. Damit kann durch die Auswahl des erfindungsgemäßen Winkelbereichs auf die Verwendung von Spezialkabel oder Kabel ohne Knickschutzhülle verzichtet werden.

Als ganz besonders vorteilhaft hat sich ein Winkel von 19° zwischen der Achse der Einstecköffnung und einer mit der Einbaubuchse verbundenen Platine herausgestellt. Daher weist der Winkel vorzugsweise einen Winkel einen Winkel von 19° ±1°, d.h. 18° bis 20°, auf. Bei einem Winkel von 19° sind die einzelnen Rahmenbedingungen derart gut erfüllt, dass die Dimensionierung als optimal angesehen werden kann. Im Bereich von ±4° um 19° sind die Rahmenbedingungen ausreichend gut erfüllt, so dass dieser Bereich als sehr gute Dimensionierung gelten kann und gleichzeitig für die Produktion der Einbaubuchse einen günstige Toleranzbereich bietet. Im Bereich von ±1° um 19° sind die Randbedingungen optimal eingehalten und es ist ein recht enger aber dennoch gut zu realisierender Toleranzbereich gegeben.

Der Grundkörper der Einbaubuchse kann prinzipiell auf verschiedenste Arten ausgebildet sein. Ein runder Querschnitt ist ebenso denkbar wie verschiedene Vielecke. Vorzugsweise ist der Grundkörper jedoch aus einem ersten quaderförmigen Abschnitt und einem zweiten quaderförmigen Abschnitt gebildet. Der erste quaderförmige Abschnitt sei der Bereich des Grundkörpers, der der Platine zugewandt ist. Entsprechend wäre die Anschlussseite als Grundfläche des ersten quaderförmigen Abschnitts gebildet. Der zweite quaderförmige Abschnitt sei der Bereich des Grundkörpers, der der Anschlussseite zugewandt ist, wobei vorzugweise die Einstecköffnung an der Grundseite des zweiten quaderförmigen Abschnitts ausgebildet ist. Dabei ist der erste quaderförmige Abschnitt gegenüber dem zweiten quaderförmigen Abschnitt geneigt. Vorzugsweise ist die Achse der Einstecköffnung parallel zu den Seiten des zweiten quaderförmigen Bereichs. Dadurch kann durch Verändern der Neigung zwischen dem ersten quaderförmigen Bereich und dem zweiten quaderförmigen Bereich der Winkel zwischen der Achse der Einstecköffnung und der Platine festgelegt werden.

Prinzipiell könnte der erste quaderförmige Bereich vergleichsweise beliebig in den zweiten quaderförmigen Bereich übergehen. So wäre in einer bevorzugten Ausgestaltung denkbar, dass der erste quaderförmige Bereich in einem Bogen in den zweiten quaderförmigen Bereich übergeht und somit ein quasi-kontinuierlicher Übergang zwischen den beiden Bereichen entsteht. Der Übergang könnte gemäß einer zweiten Ausgestaltung jedoch auch gestuft erfolgen, so dass der Grundkörper durch zwei gegeneinander geneigte Quader ausgebildet ist. Dabei sind die beiden quaderförmigen Bereiche - unabhängig von dem Ausgestalten des Übergangs zwischen den Bereichen - vorzugsweise derart ausgestaltet, dass zwei gegenüberliegende Seiten des ersten quaderförmigen Bereichs und zwei gegenüberliegende Seiten des zweiten quaderförmigen Bereichs jeweils in einer Ebene liegen.

Durch die erfindungsgemäße Ausgestaltung der Einbaubuchse ist es möglich, die "Höhe" der Einbaubuchse, d.h. der Abstand zwischen einer mit der Einbaubuchse verbundenen Platine und dem am weitesten von dieser Platine entfernten Punkt der Einbaubuchse, relativ beliebig zu gestalten. Insbesondere bei Verwendung eines ersten quaderförmigen Bereichs und eines zweiten quaderförmigen Bereichs kann dies durch Verändern der Länge des ersten quaderförmigen Bereichs und/oder des zweiten quaderförmigen Bereichs erfolgen. Auf diese Weise kann relativ beliebig auf die üblichen Einbausituationen eingegangen werden. Wenn die Platine parallel zu der Montageseite des Tragschienengehäuses, d.h. die Seite des Gehäuses, die der Tragschiene zugewandt ist, angeordnet ist und in dem Tragschienengehäuse Befestigungsmittel, beispielsweise in Form von Schienen, vorgesehen sind, so kann durch Wahl der Länge des ersten quaderförmigen Bereichs festgelegt werden, an welcher Position relativ zu dem Gehäuse die Einbaubuchse endet. Vorzugsweise ist die Einbaubuchse derart ausgestaltet, dass sich der Grundkörper in einer Richtung senkrecht zu der mit der Einbaubuchse verbundenen Platine zwischen 20 mm und 25 mm erstreckt.

Vorzugsweise sind innerhalb der Einstecköffnung Kontakte ausgebildet, die einen elektrischen Kontakt zu korrespondierenden Kontakten an einem in die Einstecköffnung eingesteckten Stecker herstellen. Die Kontakte innerhalb der Einstecköffnung sind wiederum mit den Anschlussmitteln an der Anschlussseite der Einbaubuchse verbunden. Der Kontakt zu den Anschlussmitteln kann durch entsprechend ausgestaltete Kontakte erfolgen oder durch leitfähige Elemente zwischen den Kontakten und den Anschlussmitteln.

Zur Bereitstellung von Statusanzeigen, wie beispielsweise dem Vorhandensein einer Verbindung oder dem Übertragen von Datenpaketen, kann bei der Einstecköffnung mindestens eine Leuchtanzeige, vorzugsweise in Form einer oder mehrerer LEDs (Licht Emittierende Diode), bereitgestellt sein. Insbesondere bei Verwendung einer RJ45-Buchse ist im Bereich neben der Vertiefung für die Rastnase an dem RJ45-Stecker Platz vorhanden, an dem entsprechende Leuchtanzeigen angeordnet sein können. Die Leuchtanzeigen könnten von einem Teil der Kommunikationseinheit angesteuert werden, der die über die Einbaubuchse empfangenen Signale verarbeitet.

Vorzugsweise ist die Einbaubuchse geschirmt ausgebildet. Die kann dadurch erreicht werden, dass das Gehäuse der Einbaubuchse metallisiert oder zumindest zu einem erheblichen Teil mit einem Metallmantel umgeben ist. Auf diese Weise kann elektromagnetische Interferenz (EMI), beispielsweise mit anderen Bestandteilen der Kommunikationseinheit, wirkungsvoll reduziert werden. Dabei können zusätzlich an dem Grundkörper EMI-Finger ausgebildet sein, die beispielsweise einen Kontakt zu einem metallisierten Bereich des Tragschienengehäuses der Kommunikationseinheit herstellen. Auf diese Weise kann die elektromagnetische Interferenz weiter reduziert werden.

Die Anschlussmittel an der Anschlussseite der Einbaubuchse sind vorzugsweise als Lötstifte oder als Lötfahnen ausgebildet. Bei einer Ausbildung als Lötstifte werden die Anschlussmittel durch korrespondierende Bohrungen in der Platine gesteckt und mit Leiterbahnen auf der der Einbaubuchse gegenüberliegenden Seite der Platine verlötet. Bei Verwendung von Lötfahnen als Anschlussmittel werden die Anschlussmittel mit Leiterbahnen auf der gleichen Seite der Platine verbunden, so dass die Einbaubuchse als SMD (Surface Mounted Device)-Bauteil ausgebildet ist.

Prinzipiell können im Zusammenhang mit der erfindungsgemäßen Kommunikationseinheit die verschiedensten Tragschienengehäuse verwendet werden. Ganz besonders bevorzugter Weise ist das Tragschienengehäuses jedoch ein Hutschienengehäuse, wie es in der deutschen Patentanmeldung 10 2014 220 196 beschrieben ist.

Auch wenn die voranstehenden Ausführungen sich im Wesentlichen auf die besonders bevorzugte Ausgestaltung der Kommunikationseinheit in einem Hutschienengehäuse und der Einbaubuchse als RJ45-Buchse beziehen, so wird ein Fachmann erkennen, dass die voranstehenden Ausführungen für andere Tragschienengehäuse und für andere Einbaubuchsen entsprechend gelten können. Der erfindungsgemäß ausgewählte Winkelbereich ist dann besonders vorteilhaft, wenn entsprechende Rahmenbedingungen hinsichtlich der Anordnung der Einbaubuchse, dem zur Verfügung stehenden Platz vor der Gehäuse bei der Einbaubuchse und hinsichtlich des Biegeradius des angeschlossenen Kabels vorhanden sind.

Es gibt nun verschiedene Möglichkeiten, die Lehre der vorliegenden Erfindung in vorteilhafter Weise auszugestalten und weiterzubilden. Dazu ist einerseits auf die dem Anspruch 1 bzw. 11 nachgeordneten Ansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen
- Fig. 1: eine schematische Darstellung eines Hutschienengehäuses in Seitenansicht zur Erläuterung einer Einbausituation,
- Fig. 2: eine Seitenansicht einer erfindungsgemäßen Kommunikationseinheit in einem Hutschienengehäuse mit einer Einbaubuchse mit einem Winkel von 19°,
- Fig. 3: einen Schnitt durch die Kommunikationseinheit nach Fig. 2 entlang der Zeichenebene nach Fig. 2,
- Fig. 4: ein Schnitt durch die in Fig. 2 verwendete erfindungsgemäße Einbaubuchse,
- Fig. 5: eine schematische Darstellung einer Kommunikationseinheit mit einer Einbaubuchse mit 30° (oberer Randbereich) und
- Fig. 6: eine schematische Darstellung einer Kommunikationseinheit mit einer Einbaubuchse mit einem Winkel von 9° (unterer Randbereich).

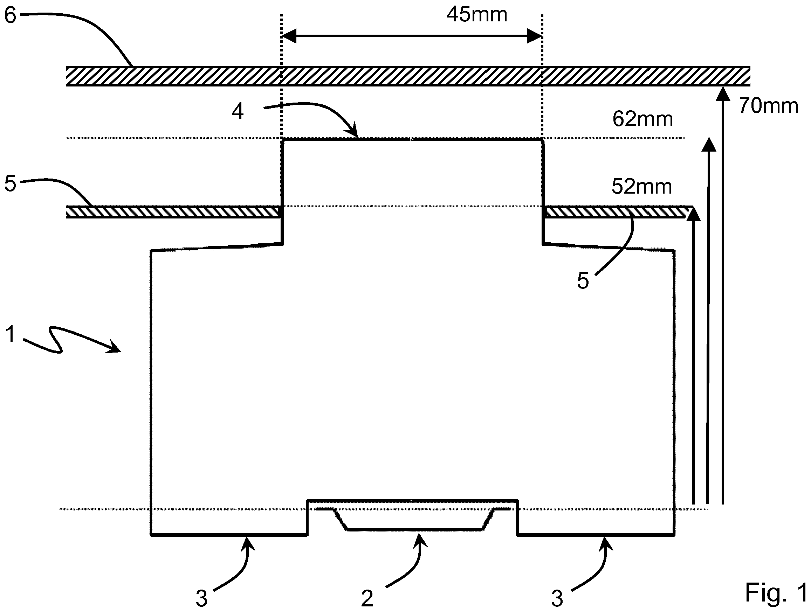

Anhand von Fig. 1 soll zunächst die den bevorzugten Ausführungsbeispielen zugrundeliegende Einbausituation näher betrachtet werden. Fig. 1 zeigt eine schematische Darstellung eines Hutschienengehäuses in einer Seitenansicht sowie die gemäß DIN 43880 vorgegebenen Einbaumaße nach Baugröße 1 bis 3. Das Hutschienengehäuse 1 ist auf einer Hutschiene 2 montiert. Die der Hutschiene 2 zugewandte Seite des Hutschienengehäuses 1 wird nachfolgend als Montageseite 3 bezeichnet. Die der Montageseite 3 gegenüberliegende Seite wird nachfolgend als Frontseite 4 bezeichnet. Die Frontseite 4 reicht durch eine Berührungsschutzabdeckung 5, die den Bereich hinter der Berührungsschutzabdeckung, d.h. auf der Seite der Hutschiene, gegenüber Berührung und Manipulation schützt. Entsprechend ist die Berührungsschutzabdeckung in der Regel verplombt. Gemäß DIN 43880 ist die Oberfläche der Berührungsschutzabdeckung 52mm von der Hutschiene 2 entfernt. Das Hutschienengehäuse 1 selbst darf maximal 10 mm über die Berührungsschutzabdeckung 5 hinausragen. Entsprechend ist die Frontseite 4 maximal 62mm von der Oberkante der Hutschiene 2 entfernt. Vor der Berührungsschutzabdeckung 5 und vor der Frontseite 4 ist eine Türe 6 angeordnet, die den Verteiler, in dem die Hutschiene 2, das Hutschienengehäuse 1 und die Berührungsschutzabdeckung 5 angeordnet sind, abschließt. Die Türe 6 hat dabei einen Abstand von 70mm von der Hutschiene 2. Die Frontseite hat eine Breite von ca. 45 mm.

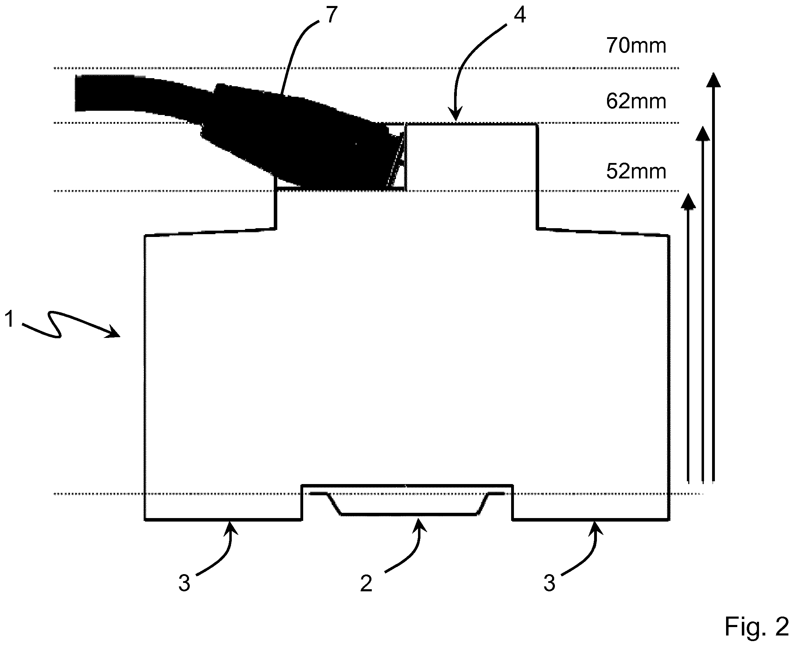

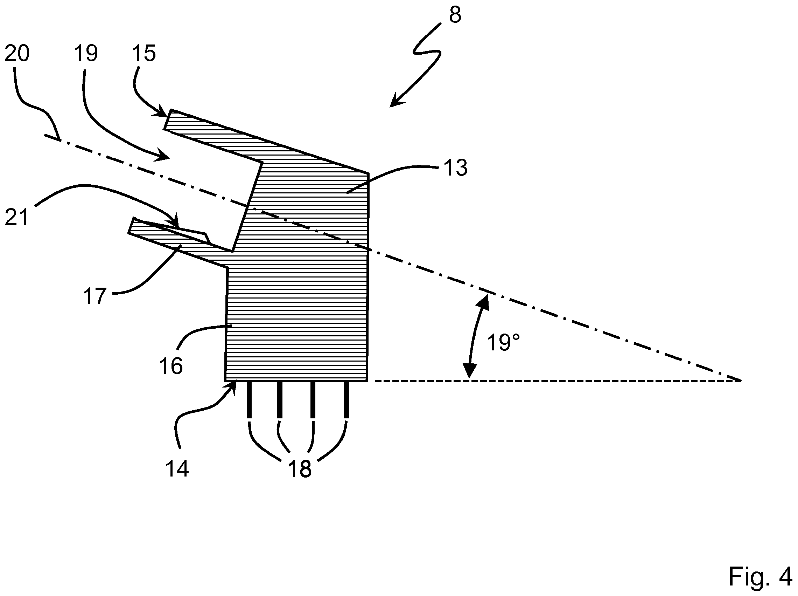

In den Fig. 2 bis 4 ist ein erstes Ausführungsbeispiel der erfindungsgemäßen Lehre in verschiedenen Ansichten und Detailgraden dargestellt. Eine durch die Einstecköffnung der Einbaubuchse definierte Achse schließt in diesem Ausführungsbeispiel einen Winkel von 19° ein, was insbesondere in Fig. 4 zu erkennen ist. Fig. 2 zeigt eine schematische Darstellung einer erfindungsgemäßen Kommunikationseinheit, die in einem Hutschienengehäuse mit den Abmessungen gemäß Fig. 1 angeordnet ist. Insbesondere ist zu erkennen, dass die Einbaubuchse nicht über die zulässigen 62 mm für das Gehäuse hinausragt. In eine hier nur ansatzweise sichtbare Anschlussbuchse ist ein Stecker 7 eingesteckt, der als Standard-RJ45-Stecker mit Knickschutzhülle ausgebildet ist.

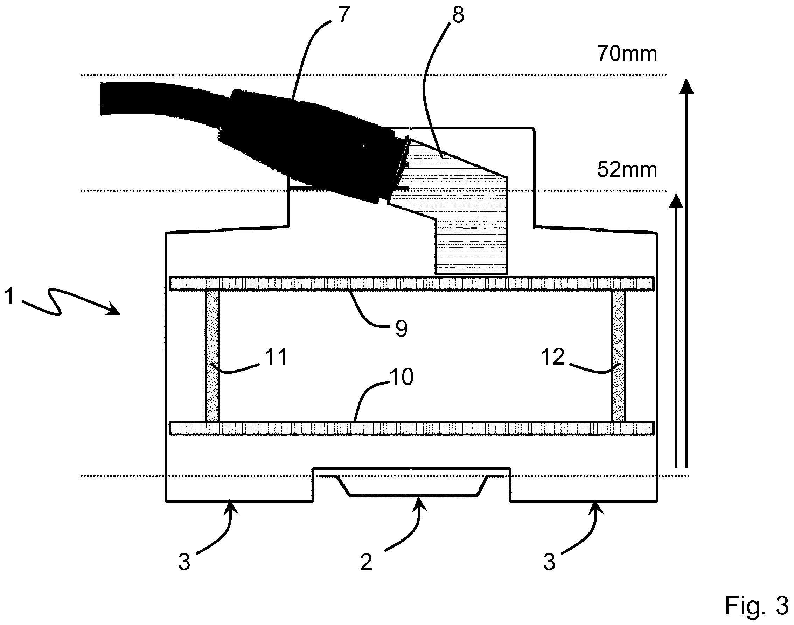

Fig. 3 zeigt einen Schnitt durch das Hutschienengehäuse 1 entlang der Zeichenebene der Fig. 2. Dadurch ist die Einbaubuchse 8 nun zu erkennen. Die Einbaubuchse 8 ist mit hier nicht eingezeichneten Anschlussmitteln auf einer Platine 9 - erste Platine im Sinne der Ansprüche - befestigt. Die Platine 9 ist parallel zu der Montageseite 3 und parallel zu der Frontseite 4 angeordnet. Parallel zu Platine 9 ist eine weitere Platine 10 angeordnet, die relativ zu Platine 9 näher an der Montageseite 3 angeordnet ist. In Fig. 3 sind beispielhaft Verbindungsstege 11 und 12 eingezeichnet, die die beiden Platinen 9 und 10 mechanisch und/oder elektrisch miteinander verbinden. Sowohl in Fig. 2 als auch in Fig. 3 ist zu erkennen, dass der Stecker 7 innerhalb des Bereichs zwischen Berührungsschutzabdeckung 5 und Türe 6 bleibt, d.h. zwischen 42 mm und 70 mm von der Hutschiene 2 entfernt. Die Höhe der Einbaubuchse beträgt dabei ca. 22 mm.

In Fig. 4 ist Einbaubuchse 8 nochmals in einer Vergrößerung und in einem Schnitt dargestellt. Als Schnittebene ist eine Ebene parallel zu der Zeichenebene der Fig. 2 und Fig. 3 gewählt. Die Einbaubuchse 8 weist einen Grundkörper 13 auf, an dem eine Anschlussseite 14 und eine Einsteckseite 15 ausgebildet sind. Der Grundkörper 13 besteht aus einem ersten quaderförmigen Abschnitt 16 und einem zweiten quaderförmigen Abschnitt 17, die gegeneinander verkippt sind und gestuft ineinander übergehen. Zwei gegenüberliegende Seiten des ersten quaderförmigen Abschnitts 16 und des zweiten quaderförmigen Abschnitts 17 liegen dabei in einer Ebene. Dies ist in Fig. 3 zu erkennen, wobei die Ebenen mit den beiden gegenüberliegenden Seiten parallel zur Zeichenebene angeordnet sind.

An der Anschlussseite 14 sind Anschlussmittel 18 ausgebildet, die als Lötstifte ausgebildet sind und von denen beispielhaft vier in Fig. 4 wiedergegeben sind. An der Einsteckseite 15 ist eine Einstecköffnung 19 ausgebildet, wobei durch die Einstecköffnung 19 eine Achse 20 definiert ist, entlang der ein eingesteckter Stecker (der Übersichtlichkeit wegen hier nicht eingezeichnet) angeordnet ist. Die Achse 20 schließt relativ zu einer mit der Einbaubuchse verbundenen Platine (in Fig. 4 durch eine gestrichelte Linie angedeutet) einen Winkel von 19° ein. In der Einstecköffnung 19 sind Kontakte 21 ausgebildet, die korrespondierende Kontakte in einem eingesteckten Stecker kontaktieren und eine Verbindung zu den Anschlussmitteln 18 herstellen.

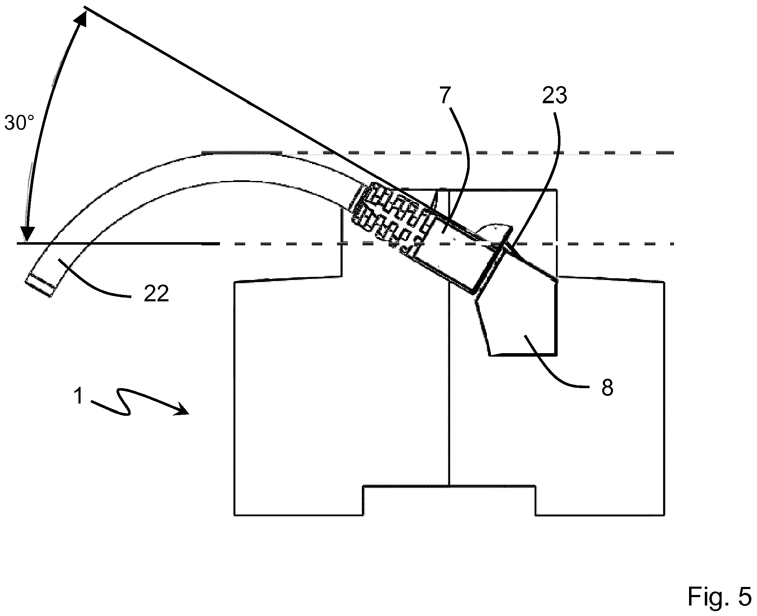

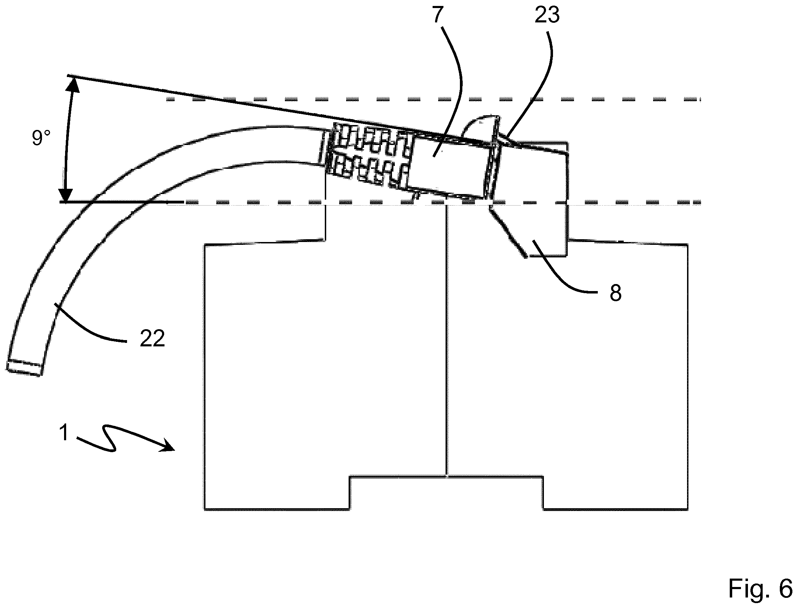

Die Fig. 5 und 6 zeigen zwei weitere Ausgestaltungen einer Kommunikationseinheit ähnlich Fig. 2. In Fig. 5 ist ein Winkel von 30° zwischen der Achse der Einstecköffnung und einer Ebene der Platine, auf der die Einbaubuchse verbunden ist, dargestellt. In Fig. 6 beträgt der Winkel 9°. Es ist zu erkennen, dass sowohl in Fig. 5 als auch in Fig. 6 die Vorgaben hinsichtlich der Dimensionierung des Hutschienengehäuses, den Vorgaben hinsichtlich der Position der Tür als auch die Vorgaben hinsichtlich des Biegeradius des Kabels 22 des eingesteckten Steckers 7 eingehalten werden können. Insbesondere ist zu erkennen, dass das Kabel 22 oberhalb der Ebene der Berührungsschutzabdeckung und unterhalb der Türe verbleibt. Gleichzeitig ist zu erkennen, dass sich eine Rastnase 23 an Stecker 7, die zum Entfernen des Steckers aus der Einbaubuchse gelöst werden muss, in unterschiedlichen Tiefen innerhalb des Gehäuses 1 befindet. Bei der Ausgestaltung nach Fig. 5 befindet sich die Rastnase 23 recht tief in Gehäuse 1. Dadurch sind Hilfsmittel notwendig, um die Rastnase 23 zu lösen. Dies kann die Sicherheit erhöhen, da sowohl ein unbeabsichtigtes Entfernen vermieden als auch ein Entfernen generell erschwert wird. Ohne entsprechendes Hilfsmittel ist der Stecker kaum zu entfernen, da die Öffnung in der Frontseite 4 des Gehäuses 1 maximal bis zur Hälfte des Gehäuses reichen wird. Bei der Ausgestaltung nach Fig. 6 ist hingegen die Rastnase 23 des Steckers 7 sehr nahe an der Oberfläche der Frontseite 4. Diese Ausgestaltung bietet sich insbesondere dann an, wenn einem Nutzer ein regelmäßiges und besonders einfaches Stecken und Entfernen der Verbindung ermöglicht werden soll. Diese Ausgestaltung erleichtert sowohl Endkunden als auch Techniker den Zugang zu der Einbaubuchse 8. Die erfindungsgemäße Ausgestaltung nach Fig. 2 stellt einen Mittelweg dar, da eine Rastnase an einem Stecker sehr nahe an der Oberfläche liegen wird, gleichzeitig aber nicht ohne weiteres gelöst werden kann.

Hinsichtlich weiterer vorteilhafter Ausgestaltungen der erfindungsgemäßen Einbaubuchse bzw. der erfindungsgemäßen Kommunikationseinheit wird zur Vermeidung von Wiederholungen auf den allgemeinen Teil der Beschreibung sowie auf die beigefügten Ansprüche verwiesen.

Schließlich sei ausdrücklich darauf hingewiesen, dass die voranstehend beschriebenen Ausführungsbeispiele lediglich zur Erörterung der beanspruchten Lehre dienen, diese jedoch nicht auf die Ausführungsbeispiele einschränken.

### Bezugszeichenliste

- 1: Hutschienengehäuse
- 2: Hutschiene
- 3: Montageseite
- 4: Frontseite
- 5: Berührungsschutzabdeckung
- 6: Türe
- 7: Stecker
- 8: Einbaubuchse
- 9: Platine (erste Platine)
- 10: Platine (weitere Platine)
- 11: Verbindungsstege
- 12: Verbindungsstege
- 13: Grundkörper
- 14: Anschlussseite
- 15: Einsteckseite
- 16: erster quaderförmiger Abschnitt
- 17: zweiter quaderförmiger Abschnitt
- 18: Anschlussmittel
- 19: Einstecköffnung
- 20: Achse
- 21: Kontakt
- 22: Kabel
- 23: Rastnase

## Patentansprüche

1. Einbaubuchse für eine Kommunikationseinheit in einem Tragschienengehäuse, mit einem Grundkörper (13), an dem eine Anschlussseite (14) und eine Einsteckseite (15) ausgebildet ist, wobei an der Anschlussseite (14) Anschlussmittel (18) zum Verbinden der Einbaubuchse mit Leiterbahnen auf einer Platine (9) der Kommunikationseinheit ausgebildet sind, wobei in der Einsteckseite (15) eine Einstecköffnung (19) zur Aufnahme eines korrespondierenden Steckers (7) ausgebildet ist und wobei durch die Einstecköffnung (19) eine Achse (20) definiert ist, entlang der ein eingesteckter Stecker (7) angeordnet ist,
**dadurch gekennzeichnet, dass** Anschlussseite (14) und Einstecköffnung (19) derart aufeinander abgestimmt sind, dass die Achse (20) der Einstecköffnung (19) relativ zu der Platinenebene einer mit der Einbaubuchse (8) über die Anschlussmittel (18) verbundenen Platine (9) einen Winkel zwischen 15° und 23° einschließt.

2. Einbaubuchse nach Anspruch 1, **dadurch gekennzeichnet, dass** die Achse (20) der Einstecköffnung (19) relativ zu einer mit der Einbaubuchse (8) verbundenen Platine (9) einen Winkel zwischen 18° und 20° einschließt.

3. Einbaubuchse nach Anspruch 1 oder 2, **dadurch gekennzeichnet, dass** der Grundkörper (13) aus einem ersten quaderförmigen Abschnitt (16) und einen zweiten quaderförmigen Abschnitt (17) ausgebildet ist, wobei die Anschlussseite (14) durch eine Grundfläche des ersten quaderförmigen Abschnitts (16) und die Einsteckseite (15) durch eine Grundfläche des zweiten quaderförmigen Abschnitts (17) definiert ist und wobei der erste quaderförmige Abschnitt (16) und der zweite quaderförmige Abschnitt (17) gegeneinander geneigt sind.

4. Einbaubuchse nach Anspruch 3, **dadurch gekennzeichnet, dass** der erste quaderförmige Abschnitt (16) in den zweiten quaderförmigen Abschnitt (17) gestuft oder in einen Bogen übergeht, wobei vorzugsweise zwei gegenüberliegende Seiten des ersten quaderförmigen Abschnitts (16) und des zweiten quaderförmigen Abschnitts (17) in einer Ebene liegen.

5. Einbaubuchse nach einem der Ansprüche 1 bis 4, **dadurch gekennzeichnet, dass** sich der Grundkörper (13) in einer Richtung senkrecht zu einer mit der Einbaubuchse (8) verbundenen Platine (9) zwischen 20 mm und 25 mm erstreckt

6. Einbaubuchse nach einem der Ansprüche 1 bis 5, **dadurch gekennzeichnet, dass** innerhalb der Einstecköffnung (19) Kontakte (21) ausgebildet sind, die einen elektrischen Kontakt zwischen korrespondierenden Kontakten an einem in die Einstecköffnung (19) eingesteckten Stecker (7) und den Anschlussmitteln (18) herstellen.

7. Einbaubuchse nach einem der Ansprüche 1 bis 6, **dadurch gekennzeichnet, dass** an der Einsteckseite (15) bei der Einstecköffnung (19) mindestens eine Leuchtanzeige für Statusanzeigen, vorzugsweise durch eine oder mehrere LED - Licht-Emittierende Diode, ausgebildet sind.

8. Einbaubuchse nach einem der Ansprüche 1 bis 7, **gekennzeichnet durch** eine Ausbildung als RJ-Buchse - Registered Jack Buchse, vorzugsweise als RJ45-Buchse.

9. Einbaubuchse nach einem der Ansprüche 1 bis 8, **dadurch gekennzeichnet, dass** die Einbaubuchse (8) geschirmt ausgebildet ist, wobei vorzugsweise zum Kontakt mit einem metallischen oder metallisierten Gehäuse an der Einsteckseite EMI-Finger ausgebildet sind.

10. Einbaubuchse nach einem der Ansprüche 1 bis 9, **dadurch gekennzeichnet, dass** die Anschlussmittel (18) als Lötstifte oder als Lötfahnen ausgebildet sind.

11. Kommunikationseinheit, insbesondere ein SmartMeter-Gateway, mit einem Gehäuse (1) zur Montage auf einer Tragschiene, vorzugsweise eine Hutschiene (2), mit mindestens einer innerhalb des Gehäuses (1) angeordneten Platine (9, 10) und mit einer Einbaubuchse (8) nach einem der Ansprüche 1 bis 10, wobei das Gehäuse (1) eine zur Tragschiene zugewandte Seite - Montageseite (3) - und eine Frontseite (4) aufweist, wobei die Einbaubuchse (8) mit einer der mindestens einen Platine - erste Platine (9) - verbunden ist, wobei die erste Platine (9) parallel zu der Montageseite (3) angeordnet ist, wodurch die Achse (20) der Einstecköffnung (19) relativ zu der Montageseite (3) einen Winkel zwischen 15° und 23° einschließt.

12. Kommunikationseinheit nach Anspruch 11, **dadurch gekennzeichnet, dass** in dem Gehäuse (1) eine Ausnehmung ausgebildet ist, durch die ein Stecker (7) in die Einbaubuchse (8) einsteckbar ist, wobei die Ausnehmung zumindest teilweise in der Frontseite (4) gebildet ist.

## Claims

1. Built-in socket for a communication unit in a carrier rail housing, having a base member (13) on which a connection side (14) and an insertion side (15) are constructed, wherein there are constructed on the connection side (14) connection means (18) for connecting the built-in socket to strip conductors on a circuit board (9) of the communication unit, wherein an insertion opening (19) is constructed in the insertion side (15) for receiving a corresponding connector (7), and wherein there is defined by the insertion opening (19) an axis (20), along which an inserted connector (7) is arranged,
**characterised in that** the connection side (14) and insertion opening (19) are adapted to each other in such a manner that the axis (20) of the insertion opening (19) relative to the circuit board plane of a circuit board (9) which is connected to the built-in socket (8) by way of the connection means (18) defines an angle between 15° and 23°.

2. Built-in socket according to claim 1, **characterised in that** the axis (20) of the insertion opening (19) defines an angle between 18° and 20° relative to a circuit board (9) which is connected to the built-in socket (8).

3. Built-in socket according to claim 1 or 2, **characterised in that** the base member (13) is formed from a first parallelepipedal portion (16) and a second parallelepipedal portion (17), wherein the connection side (14) is defined by a base face of the first parallelepipedal portion (16) and the insertion side (15) is defined by a base face of the second parallelepipedal portion (17), and wherein the first parallelepipedal portion (16) and the second parallelepipedal portion (17) are inclined relative to each other.

4. Built-in socket according to claim 3, **characterised in that** the first parallelepipedal portion (16) merges into the second parallelepipedal portion (17) in a stepped manner or in a curve, wherein preferably two opposing sides of the first parallelepipedal portion (16) and the second parallelepipedal portion (17) are located in one plane.

5. Built-in socket according to any one of claims 1 to 4, **characterised in that** the base member (13) extends in a direction perpendicular to a circuit board (9) which is connected to the built-in socket (8) between 20 mm and 25 mm.

6. Built-in socket according to any one of claims 1 to 5, **characterised in that** there are formed within the insertion opening (19) contacts (21) which produce an electrical contact between corresponding contacts on a connector (7) which is inserted in the insertion opening (19) and the connection means (18).

7. Built-in socket according to any one of claims 1 to 6, **characterised in that** there is/are constructed at the insertion side (15) in the insertion opening (19) at least one indicator light for status indications, preferably by means of one or more LEDs - Light Emitting Diodes.

8. Built-in socket according to any one of claims 1 to 7, **characterised by** a construction as an RJ socket - Registered Jack socket, preferably as an RJ45 socket.

9. Built-in socket according to any one of claims 1 to 8, **characterised in that** the built-in socket (8) is constructed in a shielded manner, wherein preferably for contact with a metal or metal-coated housing EMI fingers are constructed at the insertion side.

10. Built-in socket according to any one of claims 1 to 9, **characterised in that** the connection means (18) are constructed as solder pins or solder tails.

11. Communication unit, in particular a Smart Meter Gateway, having a housing (1) for assembly on a carrier rail, preferably a top-hat rail (2), having at least one circuit board (9, 10) which is arranged inside the housing (1) and having a built-in socket (8) according to any one of claims 1 to 10, wherein the housing (1) has a side facing the carrier rail - assembly side (3) - and a front side (4), wherein the built-in socket (8) is connected to one of the at least one circuit boards - first circuit board (9) - , wherein the first circuit board (9) is arranged parallel with the assembly side (3), whereby the axis (20) of the insertion opening (19) defines an angle between 15° and 23° relative to the assembly side (3).

12. Communication unit according to claim 11, **characterised in that** there is formed in the housing (1) a recess through which a connector (7) can be inserted into the built-in socket (8), wherein the recess is formed at least partially in the front side (4).

## Revendications

1. Prise encastrée pour une unité de communication dans un boîtier à rail porteur, avec un corps de base (13), sur lequel sont formés un côté de raccordement (14) et un côté d'insertion (15), moyennant quoi, sur le côté de raccordement (14) sont formés des moyens de raccordement (18) pour la liaison de la prise encastrée sur une platine (9) de l'unité de communication, moyennant quoi, sur le côté d'insertion (15) est formée une ouverture d'insertion (19) pour le logement d'un connecteur (7) et, à travers l'ouverture d'insertion (19), un axe (20) étant défini, le long duquel est disposé un connecteur (7) inséré,
**caractérisée en ce que** le côté de raccordement (14) et l'ouverture d'insertion (19) sont adaptés l'un à l'autre de façon à ce que l'axe (20) de l'ouverture d'insertion (19) forme, par rapport au plan de la platine (9) reliée avec la prise encastrée (8) par l'intermédiaire des moyens de raccordement (18), un angle entre 15° et 23°.

2. Prise encastrée selon la revendication 1, **caractérisée en ce que** l'axe (20) de l'ouverture d'insertion (19) forme, par rapport à une platine (9) reliée avec la prise encastrée (8), un angle entre 18° et 20°.

3. Prise encastrée selon la revendication 1 ou 2, **caractérisée en ce que** le corps de base (13) est constitué d'une première portion parallélépipédique (16) et d'une deuxième portion parallélépipédique (17), le côté de raccordement (14) étant défini par une surface de base de la première portion parallélépipédique (16) et le côté d'insertion (15) étant défini par une surface de base de la deuxième portion parallélépipédique (17) et la première portion parallélépipédique (16) et la deuxième portion parallélépipédique (17) étant inclinées l'une par rapport à l'autre.

4. Prise encastrée selon la revendication 3, **caractérisée en ce que** la première portion parallélépipédique (16) se transforme par étapes dans la deuxième portion parallélépipédique (17) ou en un arc de cercle, de préférence deux côtés opposés de la première portion parallélépipédique (16) et de la deuxième portion parallélépipédique (17) se trouvant dans un plan.

5. Prise encastrée selon l'une des revendications 1 à 4, **caractérisée en ce que** le corps de base (13) s'étend, dans une direction perpendiculaire à une platine (9) reliée avec la prise encastrée (8), sur 20 mm à 25 mm.

6. Prise encastrée selon l'une des revendications 1 à 5, **caractérisée en ce que**, à l'intérieur de l'ouverture d'insertion (19) sont formés des contacts (21) qui établissent un contact électrique entre des contacts correspondants sur un connecteur (7) inséré dans l'ouverture d'insertion (19) et les moyens de raccordement (18).

7. Prise encastrée selon l'une des revendications 1 à 6, **caractérisée en ce que**, sur le côté d'insertion (15), près de l'ouverture d'insertion (19), se trouve au moins un affichage lumineux pour l'affichage d'états, de préférence à l'aide d'une ou plusieurs LED, diodes électroluminescentes.

8. Prise encastrée selon l'une des revendications 1 à 7, **caractérisée par** une conception sous la forme d'une prise RJ, Registered Jack, de préférence sous la forme d'une prise RJ45.

9. Prise encastrée selon l'une des revendications 1 à 8, **caractérisée en ce que** la prise encastrée (8) est blindée, de préférence des broches EMI étant prévues sur le côté d'insertion pour le contact avec un boîtier métallique ou métallisé.

10. Prise encastrée selon l'une des revendications 1 à 9, **caractérisée en ce que** les moyens de raccordement (18) sont conçus comme des broches à souder ou comme des picots à souder.

11. Unité de communication, plus particulièrement un SmartMeter-Gateway, avec un boîtier (1) pour le montage sur un rail porteur, de préférence un rail DIN (2), avec au moins une platine (9, 10) disposée à l'intérieur du boîtier (1) et avec une prise encastrée (8) selon l'une des revendications 1 à 10, le boîtier (1) comprenant un côté orienté vers le rail porteur, le côté de montage (3), et un côté frontal (4), la prise encastrée (8) étant reliée avec d'au moins une platine, la première platine (9), la première platine (9) étant disposée parallèlement au côté de montage (3), de façon à ce que l'axe (20) de l'ouverture d'insertion (19) forme, par rapport au côté de montage (3), un angle entre 15° et 23°.

12. Unité de communication selon la revendication 11, **caractérisée en ce que**, dans le boîtier (1) est formé un évidement à travers lequel un connecteur (7) peut être inséré dans la prise encastrée (8), l'évidement étant réalisé au moins partiellement dans le côté frontal (4).
